# EUROPÄISCHE PATENTSCHRIFT

(11) **EP 2 984 507 B1**
(45) Veröffentlichungstag und Bekanntmachung des Hinweises auf die Patenterteilung: **17.05.2017**
(21) Anmeldenummer: 14723693.9
(22) Anmeldetag: 10.04.2014
(51) Int. Cl.: G02B 3/00, H01L 31/042, H01L 31/052, F21S 8/00

(54) **VORRICHTUNG UND VERFAHREN ZUR OPTIMALEN JUSTIERUNG DER LINSENPLATTE IN EINEM CPV-MODUL**
DEVICE AND METHOD FOR OPTIMALLY ADJUSTING THE LENS PLATE IN A CPV MODULE
DISPOSITIF ET PROCÉDÉ D'ALIGNEMENT OPTIMAL D'UNE PLAQUE LENTICULAIRE DANS UN MODULE PVC

(30) Priorität: 11.04.2013 DE 102013006264
(43) Veröffentlichungstag der Anmeldung: 17.02.2016
(73) Patentinhaber: Grenzebach Maschinenbau GmbH, 86663 Asbach-Baeumenheim (DE)
(72) Erfinder: NEUHÄUSLER, Ulrich, 86420 Diedorf (DE)
(74) Vertreter: Kindermann, Peter
(86) Internationale Anmeldenummer: PCT/DE2014/000186
(87) Internationale Veröffentlichungsnummer: WO 2014/166477

(56) Entgegenhaltungen:
- EP-A1- 2 071 634
- US-A- 5 707 458
- US-A1- 2008 115 830

## Beschreibung

Bereits seit vielen Jahren gibt es in der Photovoltaik Ansätze, mit konzentrierter Solarstrahlung zu arbeiten. Hierbei wird die Strahlung der Sonne mittels Spiegeln und / oder Linsen konzentriert, und auf spezielle Konzentrator - Solarzellen gerichtet.

Entsprechende Systeme konzentrierender Photovoltaik (Concentrating Photovoltaics, CPV) werden derzeit im spanischen Solarforschungsinstitut Instituto de Sistemas Fotovoltaicos de Concentracion (ISFOC) in Kastilien bei Puertollano getestet. Sie bündeln das Sonnenlicht mit Linsen oder Spiegeln auf die vierhundertbis tausendfache Intensität, bevor es auf kleine Solarzellen trifft, die deutlich effizienter sind als klassische Silizium - Solarzellen. Hersteller aus vielen Teilen der Welt haben auf dem dortigen Testgelände CPV - Module installiert. Derzeit sind auf diesem Gelände etwa tausend Module installiert. Die Forscher entwickeln unter anderem Ertragsprognosen und testen die Langzeitstabilität, um dieser Technologie den Übergang aus der Entwicklung in die Märkte zu erleichtern.

Bisher sind weltweit 50 - 100 CPV Pilotanlagen in Betrieb (http://www.interpv.net/market/market_view.asp?idx=567&part_code=01). Ihre Gesamtleistung beträgt etwa 30 Megawatt. Eine aktuelle Studie des amerikanischen Marktforschungsinstituts Greentechmedia Research sagt dieser Technologie aber eine steigende Karriere voraus und auch das Journal 'PV Manufacturing' prognostiziert in der Ausgabe 13 (Sep. 2011) einen steigenden Bedarf an automatisierter Fertigungskapazität.

Das Herzstück solcher Anlagen sind die Hochleistungssolarzellen, die derzeit vor allem im Weltraum im Einsatz sind. Dort versorgen sie schon seit Jahren Satelliten und Roboter mit Strom. Statt Silizium enthalten diese Zellen so genannte Verbindungshalbleiter aus Gallium, Indium, Arsen oder Phosphor. Sie bestehen aus mehreren verschiedenen Halbleiterschichten, von denen jede einen anderen Bereich des Sonnenlichtspektrums verarbeitet, während klassische Siliziumzellen nur einen geringeren Teil des Sonnenlichtspektrums in elektrischen Strom umwandeln können.

Aus der Patentliteratur ist unter anderem folgender Stand der Technik bekannt.

In der US 4 834 805 A wird ein photovoltaisches Kraft-Modul offenbart mit den folgenden Merkmalen.

Einer Anordnung von photovoltaischen Halbleiter-Kristallzellen, verteilt in individuellen Zell-Standorten in einem geschichteten Substrat, wobei sie von zwei elektrisch leitenden Schichten eingeschlossen und mittels einer Isolierschicht getrennt sind. Ferner besteht dieses Modul aus einer lichtfördernden Schicht aus Linsen, die in einer Entfernung zu dem geschichteten Substrat angeordnet ist, wobei einfallende Strahlung in der lichtfördernden Schicht mittels der Linsen in das Substrat fokussiert wird, und wobei die Dicke der Linsenschicht, der Substratschicht und des Raums dazwischen weniger als 2 inch beträgt.

Aus der DE 10 2006 007 472 A1 ist ein photovoltaisches Konzentratormodul mit einer Linsenplatte und einer Bodenplatte, auf welcher Solarzellen untergebracht sind, und einem Rahmen bekannt, wobei der Rahmen die Linsenplatte und die Bodenplatte verbindend, längs des Randes der Linsenplatte und der Bodenplatte umlaufend angeordnet ist.

Dieses bekannte Konzentratormodul soll dahingehend verbessert werden, dass es kostengünstig hergestellt werden kann, langlebig ist, und es erlaubt, einfach und flexibel zusätzliche Komponenten zu integrieren, die auf der Linsenplatte oder der Bodenplatte nicht oder nur schwierig untergebracht werden können. Darüber hinaus soll ein Verfahren entwickelt werden, das die Herstellung solcher Konzentratormodule ermöglicht.

Die hier gestellte Aufgabe wird dadurch gelöst, dass entlang des Rahmens zwischen der Linsenplatte und dem Rahmen und/oder der Bodenplatte und dem Rahmen zum einen mindestens eine erste Dichtmasse und/oder Klebemasse und zum anderen mindestens eine zweite Dichtmasse zumindest auf einem Teil der Länge des Rahmens umlaufend angeordnet ist, wobei die beiden Dicht- und/oder Klebemassen sich bezüglich ihrer Aushärtezeit und/oder Gasdurchlässigkeit unterscheiden.

Die Druckschrift EP 2.071 634 A1 offenbart ein Verfahren zum Justieren einer Linsenplatte relativ zu einer Anordnung von Solar-Modulen.

Ferner ist aus der Druckschrift US 2008/115830 A1 eine Anordnung zum Testen von solaren Konzentrator-Modulen bekannt.

Schließlich offenbart die Druckschrift US 5 707 458 A weitere Licht umwandelnde Solar-Module, welche Quadrantensensoren aufweisen.

Die DE 10 2006 034 793 A1 offenbart eine Testvorrichtung für ein PV-Konzentratormodul, ein Verfahren zum Testen eines PV-Konzentratormoduls mit Hilfe dieser Testvorrichtung sowie ein Herstellverfahren eines mit dieser getesteten PV-Konzentratormoduls. PV steht hierbei für Photovoltaic. Dieser Druckschrift liegt die Aufgabe zugrunde, eine Möglichkeit zur Qualitätssicherung für ein PV-Konzentratormodul und insbesondere eine Möglichkeit zum Testen des Wirkungsgrades und/oder anderer technischer Parameter eines PV-Konzentratormoduls vor der Endmontage und/oder nach der Endmontage zum Testen des fertigen Moduls zu schaffen. Es gilt auch, ein Testverfahren zum Testen, bzw. ein Herstellverfahren zum Herstellen eines PV-Konzentratormoduls bereitzustellen, so dass ein PV-Konzentratormodul einfach zu testen, bzw. mit einer zuverlässigen Qualität herzustellen ist. Zur Lösung dieser Aufgabe wird nach dem Anspruch 1 eine Testvorrichtung für ein PV-Konzentratormodul mit einer ersten Lichtquelle zum Erzeugen eines Sonneneinstrahlung simulierenden Lichtes beansprucht, das weiter eine Optik enthält, die die von der ersten Lichtquelle ausgehenden Lichtstrahlen mit einer Divergenz der einzelnen Lichtstrahlen von unter 2° bündelt und zum Richten dieses Lichtbündels auf eine Lichteintrittsfläche des PV-Konzentratormoduls geeignet ist. Ferner weist diese Testvorrichtung ein Messgerät zum Messen eines Ausgangssignals des durch das Lichtbündel bestrahlten PV-Konzentratormoduls auf.

In dieser Druckschrift ist das dort offenbarte Testverfahren auch zur Anwendung vor und/oder nach der Endmontage zur Qualitätssicherung vorgesehen, vgl. hierzu auch den Anspruch 25. Eine Anwendung der hier beschriebenen Funktionsabläufe, oder Teilen davon, direkt im Produktionsprozess ist jedoch nicht vorgesehen.

Der erfindungsgemäßen Vorrichtung bzw. dem entsprechenden Verfahren liegt die Aufgabe zugrunde, eine Vorrichtung und ein Verfahren vorzustellen mit dem industriell hergestellte Konzentratormodule preiswert und zuverlässig hergestellt werden können und eine zuverlässige Endprüfung durchgeführt werden kann, sodass im praktischen Betrieb eine hohe Langzeitstabilität eines Konzentratormoduls erreicht wird
Diese Aufgabe wird mit einer Vorrichtung nach einem der Ansprüche 1 und 2 oder mit einem Verfahren gemäß einem der Ansprüche 5 und 6 gelöst. Bevorzugte Ausführungsformen sind in den abhängigen Ansprüchen 2-4, 7, 8 definiert.

Die erfindungsgemäße Vorrichtung wird im Folgenden näher beschrieben. Es zeigen dabei im Einzelnen:
Fig.1: eine Darstellung des prinzipiellen Aufbaus eines CPV - Moduls
Fig.2: eine Darstellung zur 1. Methode einer Justierung einer Linsenplatte
Fig:3: eine Darstellung zur 2. Methode einer Justierung einer Linsenplatte
Fig.4: eine prinzipielle Übersicht eines Justierungsvorgangs
Fig.5: eine Übersicht über die Stromverteilung eines Quadrantensensors
Fig.6: Strom - und Spannungsverlauf in einem CPV - Sensor.

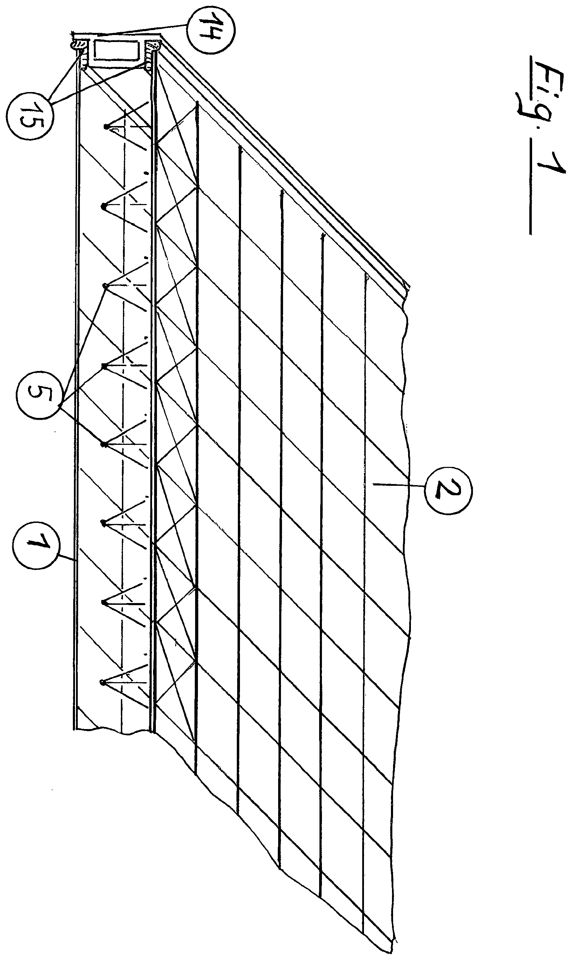

Die Fig.1 zeigt eine Darstellung des prinzipiellen Aufbaus eines CPV - Moduls.

Ein CPV - Modul besteht im Wesentlichen aus einer Sensorträgerplatte 1, die eine Vielzahl an nebeneinander angeordneten CPV - Sensoren 5 enthält, und einer parallel darüber ausgerichteten Linsenplatte 2, die ebenfalls aus einer Vielzahl von nebeneinander angeordneten Linsen, meist Fresnel - Linsen, besteht. Zur Halterung der beiden Platten 1 und 2 dient ein, in der Fig.1 auf der linken Seite im Querschnitt dargestellter Modulrahmen 14. Die den Abstand der beiden Platten 1 und 2 im Wesentlichen bestimmende Baugröße ist die Höhe des Modulrahmens 14. Diese Höhe des Modulrahmens 14 entspricht der Brennweite des in der Linsenplatte 2 verwendeten Linsentyps. Hierdurch wird gewährleistet, dass auf die Linsenplatte 2, in parallel verlaufenden Lichtstrahlen von der Sonne, einfallendes Sonnenlicht exakt im Zentrum des, jeder Linse zugeordneten, CPV - Sensors 5 konzentriert wird. Dies ist jedoch nicht nur in horizontaler X - Y - Richtung erforderlich, sondern auch in vertikaler Richtung. Deshalb ist bei der Justierung einer Linsenplatte 2 auch die Dicke der Silikon - Dichtmasse 15 zwischen dem Modulrahmen 14 und der Linsenplatte 2, sowie zwischen dem Modulrahmen 14 und der Sensorträgerplatte 1, zu berücksichtigen. Die Dicke der Silikon - Dichtmasse 15 zwischen der Sensorträgerplatte 1 und dem Modulrahmen 14 liegt im Wesentlichen fest und kann aber während des Fertigungsprozesses in gewissen Grenzen variiert werden. Zum Zeitpunkt der Justierung einer Linsenplatte ist die Sensorträgerplatte 1 jedoch schon mit dem Modulrahmen 14 verbunden.

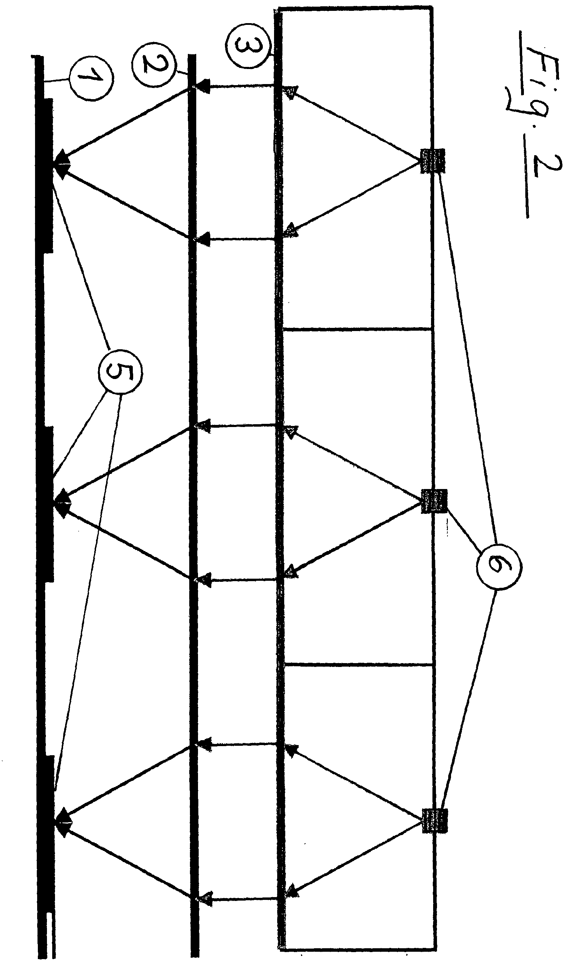

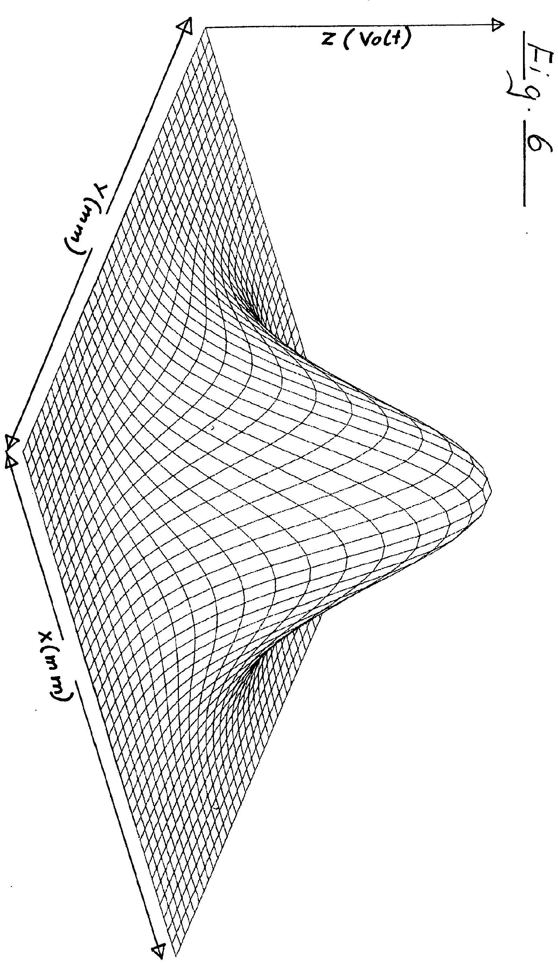

Die Fig.2 zeigt eine Darstellung zur 1. Methode einer Justierung einer Linsenplatte 2. Bei der hier gezeigten, so genannten, 1. Methode handelt es sich um ein Verfahren bei dem der natürliche Vorgang der Sonnenbestrahlung dadurch simuliert wird, dass der zu justierenden Linsenplatte 2 eine weitere feste Linsenplatte 3 mit identischen Abmessungen der Linsen wie Linsenplatte 2 in paralleler Lage vorgeschaltet wird, wobei in den Brennpunkten der Linsen auf der Linsenplatte 3 punktförmige Lichtquellen installiert sind. Auf diese Weise wird gewährleistet, dass die feste Linsenplatte 3 parallel verlaufende Lichtstrahlen in der Richtung der zu justierenden Linsenplatte 2 aussendet. Wird nunmehr die zu justierende Linsenplatte 2 inkrementell in einer horizontalen Richtung verschoben, so werden die von der Linsenplatte 2 beleuchteten CPV - Sensoren 5 einzeln, und natürlich auch in der Summe, eine unterschiedliche elektrische Spannung einen unterschiedlichen Strom erzeugen. Mittels einer planvollen Strategie von Schritten der Verschiebung der Linsenplatte 2 und jeweils einer anschließenden Spannungs- oder Strommessung kann dann die optimale Ausrichtung der Linsenplatte 2 in Bezug auf die Sensorenträgerplatte 1 ermittelt werden. Für einen als ideal angenommenen Receiverchip homogener Sensitivität über die gesamte Sensorfläche ist die optimale Ausrichtung dadurch gekennzeichnet, dass an der Sensorträgerplatte eine maximale elektrische Leistung gemessen wird. Zur Illustration ist in Fig.6 ein qualitativhoher, modellhafter Verlauf einer solchen zweidimensionalen Strom- bzw. Spannungsverteilung gezeigt. Bei kreisförmigen Sensoren, die nicht über den gesamten Bereich eine homogene Sensitivität aufweisen, kann der tatsächliche Strom-/Spannungs-Verlauf gegenüber dem qualitativen Beispiel abweichen. Es ist dann aufgrund von Symmetrieüberlegungen der optimale Arbeitspunkt zu bestimmen.

Ausgehend von dieser optimalen Ausrichtung in horizontaler Richtung kann dann eine Justierung in vertikaler Richtung erfolgen, die von einem Spannungs - und / oder Strommaximum gekennzeichnet ist und im Wesentlichen die Dicke, bzw. die Masse der später eingetragenen Silikon - Dichtmasse bestimmt.

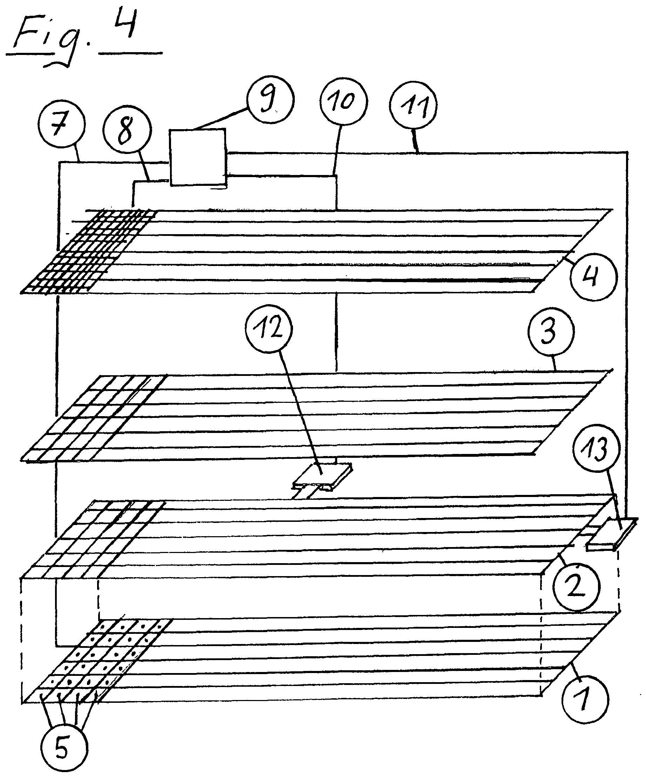

Eine prinzipielle Darstellung eines solchen Justierungsvorgangs ist der Fig.4 zu entnehmen.

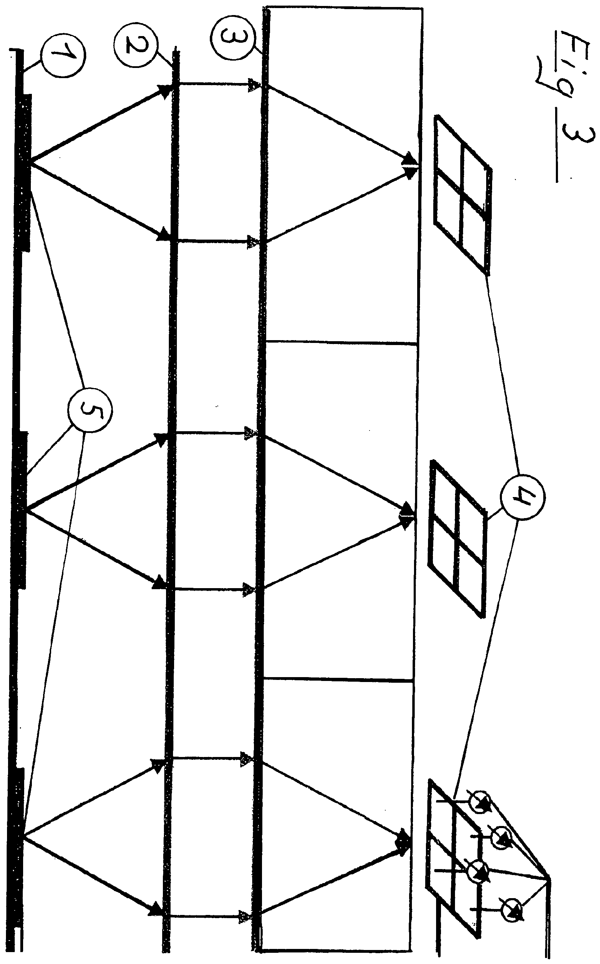

Fig.3 zeigt eine weitere 2. Methode mit ähnlichem Aufbau wie bei der in der Fig. 2 bereits dargestellten 1. Methode, jedoch mit umgekehrtem Strahlengang, also gewissermaßen einem inversen Betrieb. Hier werden die CPV - Sensoren 5 nicht hinsichtlich ihrer elektrischen Leistung bewertet, sondern werden selbst zu lichtemittierenden Elementen mit steuerbarer Leistung gemäß dem Elektrolumineszenzeffekt, indem an die einzelnen CPV - Sensoren 5 selbst jeweils ein bestimmter elektrischer Gleichstrom eingespeist wird und das von diesen ausgesendete Licht mittels Quadrantensensoren 4 detektiert und quantitativ bewertet wird. Der Abstand der CPV - Sensoren 5 zu der Linsenplatte 2 entspricht im Wesentlichen der Brennweite der in der Linsenplatte 2 verwendeten Linsen, was zu parallel verlaufenden Lichtstrahlen zwischen der Linsenplatte 2 und der automatisch zu den Quadrantensensoren 4, vorjustierten Linsenplatte 3 führt. Die Linsenplatte 3 kann in X Y und Z Richtung des Koordinatensystem verschoben werden. Die Justierrvorrichtung für die Linsenplatte 3 ist aus Gründen der Übersichtlichkeit nicht dargestellt. Da die Quadrantensensoren 4 im Abstand der Brennweite der, in der zu den Quadrantensensoren 4 ausgerichteten Position, fixierten Linsenplatte 3 verwendeten Linsen angebracht sind, wird jeder leuchtende CPV-Sensor 5 auf die entsprechende Quadratenphotodiode 4 abgebildet. Diese Abbildung erfolgt als 1:1 Abbildung, wenn die fixierte Linsenplatte 3 die gleiche Brennweite aufweist wie die auszurichtende Linsenplatte 2. Es ist grundsätzlich aber auch eine verkleinernde Abbildung (Brennweite der Linsenplatte 3 ist kleiner als die Brennweite der Linsenplatte 2) oder eine vergrößernde Abbildung (Brennweite der Linsenplatte 3 ist größer als die Brennweite der Linsenplatte 2) möglich. Aus Gründen der Vereinfachung und Austauschbarkeit bietet sich jedoch an, dass die Linsenplatten 2 und 3 nicht nur in den Linsenabmessungen, sondern auch in ihrer Brennweite identisch sind, d.h. daß derselbe Linsenplattentyp verwendet werden kann.

Die Fig.4 zeigt eine prinzipielle Übersicht eines Justierungsvorgangs einer Linsenplatte 2 nach der so genannten 2. Methode. Es sind hier vier verschiedene Ebenen gezeigt, von denen die unterste eine Sensorträgerplatte 1 mit einer Anzahl CPV - Sensoren 5 symbolisiert. Die nächste, folgende Ebene zeigt eine zugehörige Linsenplatte 2 mit einer hinteren Justiervorrichtung 12 und einer vorderen Justiervorrichtung 13. Diese beiden Justiervorrichtungen 12 und 13 ermöglichen eine Verschiebung der Linsenplatte 2 in zwei horizontalen Richtungen X und Y in einem dreidimensionalen Koordinatensystem XY und Z, wobei die Möglichkeit einer Verschiebung in Z - Richtung hier aus Gründen der Übersicht nicht dargestellt ist. Die nächste Ebene versinnbildlicht eine feste Linsenplatte 3, wie sie jeweils in der Beschreibung der Fig.2, bzw. der Fig.3 erwähnt ist.

In der obersten Ebene der Fig. 4 sind die Quadrantensensoren 4 angedeutet. Symbolisch für alle dort installierten Quadrantensensoren ist hier eine Datenleitung 8 zu einem Steuergerät 9 dargestellt. Dieses Steuergerät 9 sorgt zugleich für die Einstellung der Stromversorgung der einzelnen CPV - Sensoren 5 über die Leitung 7. Des Weiteren steuert das Steuergerät 9 die hintere Justiervorrichtung 12 und die vordere Justiervorrichtung 13 mittels der Steuerleitungen 10, bzw.11.

Die Justierung der Linsenplatte 2 in vertikaler Z - Richtung ist hier ebenfalls nicht dargestellt.

Im Falle eines Justiervorganges nach der 1. Methode befinden sich an der Stelle der Quadrantensensoren 4 punktförmige Lichtquellen, zum Beispiel LED - Leuchten, und das Steuergerät 9 dient mit der Steuerleitung 7 nicht der Stromzuführung der CPV - Sensoren sondern entnimmt diesen die von ihnen erzeugte elektrische Leistung und bringt sie zur Auswertung.

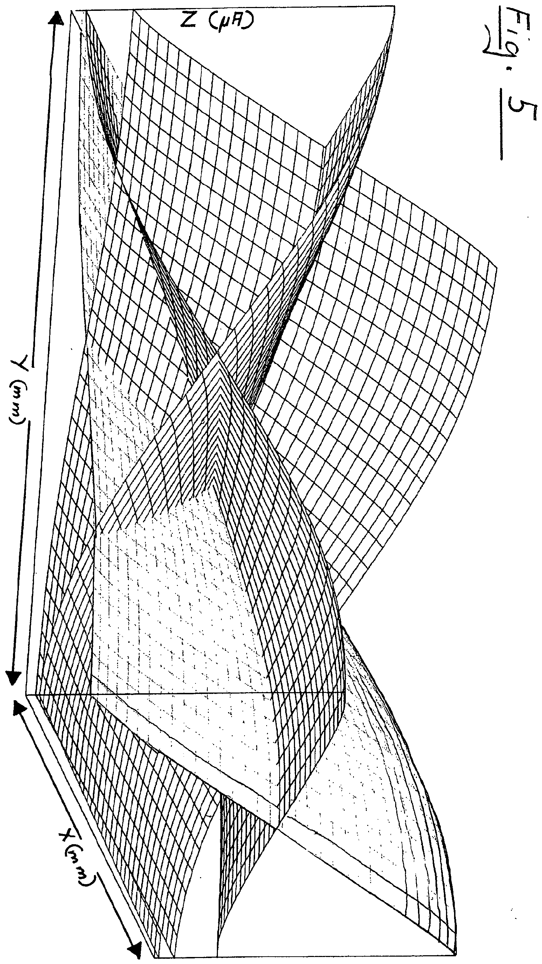

Fig.5 zeigt eine schematische Übersicht über die qualitativ zu erwartende Stromverteilung in den vier Quadranten eines Quadrantensensors 4 in Abhängigkeit von der X- und Y-Position der auszurichtenden Linsenplatte 2. Der Ursprung der 4 Quadraten in dieser Diode liegt auf der optischen Achse, optimale Ausrichtung ist daher genau dann gegeben, wenn an allen vier Quadranten ein identischer Diodenstrom gemessen werden kann , wenn die vier Differenzsignale paarweise benachbarter Dioden minimal sind.

Die Positionierungsgenauigkeit für diese Meßmethode hängt von der erreichbaren Genauigkeit des mechanischen Verschiebeprozesses ab. Durch eine Kompensation der mechanischen Toleranzen ist eine Genauigkeit von unter 20µm erreichbar. Für diese Meßanordnung liegen die zu erwartenden Signale von einer Silizium-Quadrantenphotodiode in der Größenordnung von 10 bis 100 µA, dies sind typsiche Werte für den Dunkelstrom im nA-Bereich. Das kann hohe Signal-Rausch-Verhältnisse ergeben.Der Signalgradient ist bei einer Ortsänderung für Methode1 und Methode 2 sehr hoch.

In der Fig. 6 ist schließlich eine Darstellung des Spannungsverlaufs in einem CPV - Sensor gezeigt.

Ein CPV - Submodul besteht typischerweise aus mehreren hundert einzelnen CPV - Sensoren. Da auch die bereits auf der Basisplatte assemblierten CPV - Sensoren einer gewissen statistischen Abweichung von ihrer Idealposition unterliegen, muß zur Bestimmung der optimalen Ausrichtung der Gesamtheit der Sensoren der CPV-Sensorenträgerplatte eine sinnvolle Auswahl von über die Linsenplatte an verschiedenen Orten verteilten CPV - Sensoren herangezogen werden. Da dann stets noch meßtechnisch nicht benutzte CPV-Sensoren verfügbar sind, können auch beide Methoden parallel eingesetzt werden, wobei dann anhand der Ergebnisse automatisch durch das Steuerungsprogramm hinsichtlich der für die Justierung benötigten XYZ -Koordinaten entsprechende Entscheidungen getroffen werden. Statt der Linsenplatte 4, wie in Fig.3 und Fig.4 beschrieben, kann die CPV-Sensoren-trägerplatte 1 des Konzentratormoduls zur Linsenplatte 4durch ein Justiersystem ausgerichtet werden. Voraussetzung ist ,die Quadrantensensoren oder LED,s sowie Linsenplatte 3 und Linsenplatte 4 sind in einer optischen Linie zueinander ausgerichtet.

Die komplexe Steuerung der beschriebenen Bewegungsabläufe erfordert ein spezielles Steuerprogramm.

### Bezugszeichenliste

- 1: Sensorenträgerplatte
- 2: Linsenplatte
- 3: feste Linsenplatte
- 4: Quadrantensensor
- 5: CPV - Sensor
- 6: punktförmige Lichtquelle
- 7: Stromversorgung für CPV - Sensoren
- 8: Datenleitung für Quadrantensensoren
- 9: Steuergerät
- 10: Steuerleitung für hintere Justiervorrichtung
- 11: Steuerleitung für vordere Justiervorrichtung
- 12: hintere Justiervorrichtung
- 13: vordere Justiervorrichtung
- 14: Modulrahmen
- 15: Silikon - Dichtmasse

## Patentansprüche

1. Vorrichtung zur optimalen Justierung der Linsenplatte (2) in einem konzentrierenden Photovoltaik (CPV)-Modul, das aus einer Mehrzahl von, in einer Fläche angeordneten CPV-Sensoren (5) in einer Sensorträgerplatte (1) und einer Mehrzahl von, darüber im Abstand ihrer Brennweite in einer Linsenplatte (2) angebrachten Linsen, besteht, wobei beide Platten (1, 2) in einem witterungsunempfindlichen Gehäuse untergebracht sind, mit den folgenden Merkmalen:
a) einer Sensorträgerplatte (1) mit einer Mehrzahl von CPV-Sensoren (5), wobei die CPV-Sensoren (5) mit einer einstellbaren elektrischen Leistung beaufschlagt werden können,
b) einer Linsenplatte (2) mit einer, der Anzahl der CPV-Sensoren entsprechenden, Anzahl an Linsen, wobei die Linsen im Wesentlichen parallel zu der horizontalen Lage der CPV-Sensoren (5) im Bereich von deren optischer Achse gelagert sind,
c) einer parallel zur Lage der Linsenplatte (2) gelagerten festen Linsenplatte (3),
d) einer, der Anzahl der CPV-Sensoren (5) entsprechenden, Anzahl von zur festen Linsenplatte (3) parallel ausgerichteten, Quadrantensensoren (4), deren geometrischer Mittelpunkt sich im Abstand der Brennweite der Linsen der festen Linsenplatte (3) auf deren optischer Achse befindet,
e) zwei Vorrichtungen (12, 13) zur Justierung der Linsenplatte (2) in zwei, im rechten Winkel zueinander ausgerichteten, horizontalen Richtungen,
f) einem Steuergerät (9) zur Auswertung von Ausgangssignalen der Quadrantensensoren (4), wobei das Steuergerät (9) in Abhängigkeit von der Beschaffenheit der Ausgangssignale der Quadrantensensoren (4) und der eingespeisten elektrischen Leistung der CPV-Sensoren (5) die beiden Vorrichtungen (12, 13) steuert.

2. Vorrichtung zur optimalen Justierung der Linsenplatte (2) in einem konzentrierenden Photovoltaik (CPV)-Modul, das aus einer Mehrzahl von, in einer Fläche angeordneten CPV-Sensoren (5) in einer Sensorträgerplatte (1) und einer Mehrzahl von, darüber im Abstand ihrer Brennweite in einer Linsenplatte (2) angebrachten Linsen, besteht, wobei beide Platten (1, 2) in einem witterungsunempfindlichen Gehäuse untergebracht sind, mit den folgenden Merkmalen:
a) einer Sensorträgerplatte (1) mit einer Mehrzahl von CPV-Sensoren (5),
b) einer Linsenplatte (2) mit einer, der Anzahl der CPV-Sensoren (5) entsprechenden, Anzahl an Linsen, wobei die Linsen im Wesentlichen parallel zu der horizontalen Lage der CPV-Sensoren (5) im Bereich von deren optischer Achse gelagert sind,
c) einer parallel zur Lage der Linsenplatte (2) gelagerten festen Linsenplatte (3),
d) einer, der Anzahl der CPV-Sensoren (5) entsprechenden Anzahl von zur festen Linsenplatte (3) parallel ausgerichteten, punktförmigen Lichtquellen (6), deren geometrischer Mittelpunkt sich im Abstand der Brennweite der Linsen der festen Linsenplatte (3) auf deren optischer Achse befindet,
e) zwei Vorrichtungen (12, 13) zur Justierung der Linsenplatte (2) in zwei, im rechten Winkel zueinander ausgerichteten, horizontalen Richtungen,
f) einem Steuergerät (9) zur Auswertung von Ausgangssignalen der CPV-Sensoren (5), wobei das Steuergerät (9) in Abhängigkeit von der Beschaffenheit der Ausgangssignale der CPV-Sensoren (5) die beiden Vorrichtungen (12, 13) steuert.

3. Vorrichtung nach einem der Ansprüche 1 oder 2, **dadurch gekennzeichnet, dass** eine weitere Vorrichtung zur Justierung der Linsenplatte (2) in vertikaler Richtung vorhanden ist.

4. Vorrichtung nach einem der Ansprüche 1 bis 3, **dadurch gekennzeichnet, dass** sie eine Vorrichtung zum fugenfreien Einpressen von Silikon-Dichtmasse (15) nach erfolgter Justierung der Linsenplatte (2) aufweist.

5. Verfahren zur optimalen Justierung der Linsenplatte (2) in einem konzentrierenden Photovoltaik (CPV)-Modul, das aus einer Mehrzahl von, in einer Fläche angeordneten CPV-Sensoren (5) in einer Sensorträgerplatte (1) und einer Mehrzahl von, darüber im Abstand ihrer Brennweite in einer Linsenplatte (2) angebrachten Linsen, besteht, wobei beide Platten (1, 2) in einem witterungsunempfindlichen Gehäuse untergebracht sind, mit den folgenden Merkmalen:
a) gegenüber einer Sensorträgerplatte (1) mit einer Mehrzahl von CPV-Sensoren (5), wobei die CPV-Sensoren (5) mit einer einstellbaren elektrischen Spannung und/oder einem einstellbaren elektrischen Strom beaufschlagt werden können, um sie zur Lichtemission anzuregen, wird die Linsenplatte (2) beweglich fixiert, wobei die Linsenplatte (2) eine, der Anzahl der CPV-Sensoren (5) entsprechende, Anzahl an Linsen aufweist, und wobei die Linsen im Wesentlichen parallel zu der horizontalen Lage der CPV-Sensoren (5) im Bereich von deren optischer Achse gelagert sind,
b) parallel zur Lage der Linsenplatte (2) wird eine feste Linsenplatte (3) gelagert, wobei diese feste Linsenplatte von parallelen Strahlenbündeln durchstrahlt wird, und wobei sich im Abstand der Brennweite der Linsen der festen Linsenplatte (3) auf der der Linsenplatte (2) abgewandten, Seite Quadrantensensoren (4) befinden,
c) die Linsenplatte (2) wird planmäßig in zwei aufeinander senkrecht stehenden horizontalen Richtungen so lange von zwei Vorrichtungen (12, 13) verschoben, bis mittels der Quadrantensensoren (4) eine optimale Ausrichtung der optischen Achsen der CPV-Sensoren (5) und den Linsen der Linsenplatte (2) erreicht ist, wobei mittels eines Steuergeräts (9) zur Auswertung von Ausgangssignalen der Quadrantensensoren (4) in Abhängigkeit von der Beschaffenheit der Ausgangssignale der Quadrantensensoren (4) und der eingespeisten Leistung der CPV-Sensoren (5) die beiden Vorrichtungen (12, 13) gesteuert werden.

6. Verfahren zur optimalen Justierung der Linsenplatte (2) in einem konzentrierenden Photovoltaik (CPV)-Modul, das aus einer Mehrzahl von, in einer Fläche angeordneten CPV-Sensoren (5) in einer Sensorträgerplatte (1) und einer Mehrzahl von, darüber im Abstand ihrer Brennweite in einer Linsenplatte (2) angebrachten Linsen, besteht, wobei beide Platten (1, 2) in einem witterungsunempfindlichen Gehäuse untergebracht sind, mit den folgenden Merkmalen:
a) gegenüber einer Sensorträgerplatte (1) mit einer Mehrzahl von CPV-Sensoren (5) wird die Linsenplatte (2) beweglich fixiert, wobei die Linsenplatte (2) eine, der Anzahl der CPV-Sensoren (5) entsprechende, Anzahl an Linsen aufweist, und wobei die Linsen im Wesentlichen parallel zu der horizontalen Lage der CPV-Sensoren (5) im Bereich von deren optischer Achse gelagert sind,
b) parallel zur Lage der Linsenplatte (2) wird eine feste Linsenplatte (3) gelagert, wobei sich im Abstand der Brennweite der Linsen der festen Linsenplatte (3) auf der der Linsenplatte (2) abgewandten Seite punktförmige Lichtquellen (6) befinden,
c) die Linsenplatte (2) wird planmäßig in zwei aufeinander senkrecht stehenden horizontalen Richtungen so lange von zwei Vorrichtungen (12, 13) verschoben, bis mittels der Ermittlung einer maximalen Ausbeute an elektrischer Leistung eine optimale Ausrichtung der optischen Achsen der CPV-Sensoren (5) und der Linsen der Linsenplatte (2) erreicht ist, wobei statistisch verteilte Inhomogenitäten im inneren Aufbau des betreffenden CPV-Sensors (5) berücksichtigt werden können.

7. Verfahren nach einem der Ansprüche 5 oder 6, **dadurch gekennzeichnet, dass** eine weitere Vorrichtung zur Justierung der Linsenplatte (2) in vertikaler Richtung vorhanden ist.

8. Verfahren nach einem der Ansprüche 5 bis 7 **dadurch gekennzeichnet, dass** nach erfolgter Justierung der Linsenplatte (2) mittels einer Vorrichtung ein fugenfreies Einpressen von Silikon-Dichtmasse (15) erfolgt.

## Claims

1. Device for optimally adjusting the lens plate (2) in a concentrating photovoltaic (CPV) module, which consists of a plurality of CPV sensors (5), which are arranged in a surface, in a sensor carrier plate (1) and a plurality of lenses, which are attached above this at the distance of the focal length thereof in a lens plate (2), wherein both plates (1, 2) are housed in a weather-insensitive housing, having the following features:
a) a sensor carrier plate (1) having a plurality of CPV sensors (5), wherein a settable electrical power can be applied to the CPV sensors (5),
b) a lens plate (2) having a number of lenses corresponding to the number of the CPV sensors, wherein the lenses are mounted essentially parallel to the horizontal location of the CPV sensors (5) in the region of the optical axis thereof,
c) a fixed lens plate (3) mounted in parallel to the location of the lens plate (2),
d) a number, corresponding to the number of CPV sensors (5), of quadrant sensors (4), which are aligned in parallel to the fixed lens plate (3), and the geometrical center point of which is located at a distance of the focal length of the fixed lenses of the lens plate (3) on the optical axis thereof,
e) two devices (12, 13) for adjusting the lens plate (2) in two horizontal directions, which are aligned at a right angle to one another,
f) a control unit (9) for analyzing output signals of the quadrant sensors (4), wherein the control unit (9) controls the two devices (12, 13) in dependence on the quality of the output signals of the quadrant sensors (4) and the supplied electrical power of the CPV sensors (5).

2. Device for optimally adjusting the lens plate (2) in a concentrating photovoltaic (CPV) module, which consists of a plurality of CPV sensors (5), which are arranged in a surface, in a sensor carrier plate (1) and a plurality of lenses, which are attached above this at the distance of the focal length thereof in a lens plate (2), wherein both plates (1, 2) are housed in a weather-insensitive housing, having the following features:
a) a sensor carrier plate (1) having a plurality of CPV sensors (5),
b) a lens plate (2) having a number of lenses corresponding to the number of the CPV sensors (5), wherein the lenses are mounted essentially parallel to the horizontal location of the CPV sensors (5) in the region of the optical axis thereof,
c) a fixed lens plate (3) mounted in parallel to the location of the lens plate (2),
d) a number, corresponding to the number of CPV sensors (5), of punctiform light sources (6), which are aligned in parallel to the fixed lens plate (3), and the geometrical center point of which is located at a distance of the focal length of the fixed lenses of the lens plate (3) on the optical axis thereof,
e) two devices (12, 13) for adjusting the lens plate (2) in two horizontal directions, which are aligned at a right angle to one another,
f) a control unit (9) for analyzing output signals of the CPV sensors (5), wherein the control unit (9) controls the two devices (12, 13) in dependence on the quality of the output signals of the CPV sensors (5).

3. Device according to any one of Claims 1 or 2, **characterized in that** a further device is provided for adjusting the lens plate (2) in the vertical direction.

4. The device according to any one of Claims 1 to 3, **characterized in that** it has a device for joint-free pressing in of silicone sealant mass (15) after completed adjustment of the lens plate (2).

5. Method for optimally adjusting the lens plate (2) in a concentrating photovoltaic (CPV) module, which consists of a plurality of CPV sensors (5), which are arranged in a surface, in a sensor carrier plate (1) and a plurality of lenses, which are attached above this at the distance of the focal length thereof in a lens plate (2), wherein both plates (1, 2) are housed in a weather-insensitive housing, having the following features:
a) opposite to a sensor carrier plate (1) having a plurality of CPV sensors (5), wherein a settable electrical voltage and/or a settable electrical current can be applied to the CPV sensors (5) to excite them to emit light, the lens plate (2) is movably fixed, wherein the lens plate (2) has a number of lenses corresponding to the number of the CPV sensors (5), and wherein the lenses are mounted essentially parallel to the horizontal location of the CPV sensors (5) in the region of the optical axis thereof,
b) a fixed lens plate (3) is mounted in parallel to the location of the lens plate (2), wherein parallel beam bundles radiate through this fixed lens plate, and wherein quadrant sensors (4) are located at the distance of the focal length of the lenses of the fixed lens plate (3) on the side facing away from the lens plate (2),
c) the lens plate (2) is displaced according to plan in two horizontal directions, which are perpendicular to one another, by two devices (12, 13) until an optimum alignment of the optical axes of the CPV sensors (5) and the lenses of the lens plate (2) is achieved by means of the quadrant sensors (4), wherein the two devices (12, 13) are controlled by means of a control unit (9) for analyzing output signals of the quadrant sensors (4) in dependence on the quality of the output signals of the quadrant sensors (4) and the supplied power of the CPV sensors (5).

6. Method for optimally adjusting the lens plate (2) in a concentrating photovoltaic (CPV) module, which consists of a plurality of CPV sensors (5), which are arranged in a surface, in a sensor carrier plate (1) and a plurality of lenses, which are attached above this at the distance of the focal length thereof in a lens plate (2), wherein both plates (1, 2) are housed in a weather-insensitive housing, having the following features:
a) opposite to a sensor carrier plate (1) having a plurality of CPV sensors (5), the lens plate (2) is movably fixed, wherein the lens plate (2) has a number of lenses corresponding to the number of the CPV sensors (5), and wherein the lenses are mounted essentially parallel to the horizontal location of the CPV sensors (5) in the region of the optical axis thereof,
b) a fixed lens plate (3) is mounted in parallel to the location of the lens plate (2), wherein punctiform light sources (6) are located at the distance of the focal length of the lenses of the fixed lens plate (3) on the side facing away from the lens plate (2),
c) the lens plate (2) is displaced according to plan in two horizontal directions, which are perpendicular to one another, by two devices (12, 13) until an optimum alignment of the optical axes of the CPV sensors (5) and the lenses of the lens plate (2) is achieved by means of the ascertainment of a maximum yield of electrical power, wherein randomly distributed inhomogeneities in the internal structure of the relevant CPV sensor (5) can be taken into consideration.

7. Method according to any one of Claims 5 or 6, **characterized in that** a further device is present for adjusting the lens plate (2) in the vertical direction.

8. Method according to any one of Claims 5 to 7, **characterized in that** joint-free pressing in of silicone sealant mass (15) is performed after completed adjustment of the lens plate (2) by means of a device.

## Revendications

1. Dispositif d'ajustement optimal de la plaque de lentilles (2) dans un module photovoltaïque à concentration (CPV), lequel se compose d'une pluralité de capteurs CPV (5) disposés en une surface dans une plaque support de capteurs (1) et d'une pluralité de lentilles montées au-dessus de celle-ci dans une plaque de lentilles (2) à un écart correspondant à leur distance focale, les deux plaques (1, 2) étant logées dans un boîtier insensible aux intempéries, possédant les caractéristiques suivantes :
a) une plaque support de capteurs (1) comprenant une pluralité de capteurs CPV (5), les capteurs CPV (5) pouvant être alimentés avec une puissance électrique réglable,
b) une plaque de lentilles (2) comprenant une pluralité de lentilles correspondant à la pluralité de capteurs CPV, les lentilles étant montées sensiblement en parallèle avec la position horizontale des capteurs CPV (5) dans la zone de leur axe optique,
c) une plaque de lentilles fixe (3) montée en parallèle avec la position de la plaque de lentilles (2),
d) une pluralité de capteurs de quadrant (4), correspondant à la pluralité de capteurs CPV (5) et orientés parallèlement à la plaque de lentilles fixe (3), dont le centre géométrique se trouve à un écart correspondant à la distance focale des lentilles de la plaque de lentilles fixe (3) sur leur axe optique,
e) deux dispositifs (12, 13) destinés à ajuster la plaque de lentilles (2) dans deux directions horizontales orientées perpendiculairement l'une par rapport à l'autre,
f) un contrôleur (9) destiné à interpréter les signaux de sortie des capteurs de quadrant (4), le contrôleur (9) commandant les deux dispositifs (12, 13) en fonction de la nature des signaux de sortie des capteurs de quadrant (4) et de la puissance électrique injectée des capteurs CPV (5).

2. Dispositif d'ajustement optimal de la plaque de lentilles (2) dans un module photovoltaïque à concentration (CPV), lequel se compose d'une pluralité de capteurs CPV (5) disposés en une surface dans une plaque support de capteurs (1) et d'une pluralité de lentilles montées au-dessus de celle-ci dans une plaque de lentilles (2) à un écart correspondant à leur distance focale, les deux plaques (1, 2) étant logées dans un boîtier insensible aux intempéries, possédant les caractéristiques suivantes :
a) une plaque support de capteurs (1) comprenant une pluralité de capteurs CPV (5),
b) une plaque de lentilles (2) comprenant une pluralité de lentilles correspondant à la pluralité de capteurs CPV, les lentilles étant montées sensiblement en parallèle avec la position horizontale des capteurs CPV (5) dans la zone de leur axe optique,
c) une plaque de lentilles fixe (3) montée en parallèle avec la position de la plaque de lentilles (2),
d) une pluralité de sources de lumière (6) ponctuelles, correspondant à la pluralité de capteurs CPV (5) et orientées parallèlement à la plaque de lentilles fixe (3), dont le centre géométrique se trouve à un écart correspondant à la distance focale des lentilles de la plaque de lentilles fixe (3) sur leur axe optique,
e) deux dispositifs (12, 13) destinés à ajuster la plaque de lentilles (2) dans deux directions horizontales orientées perpendiculairement l'une par rapport à l'autre,
f) un contrôleur (9) destiné à interpréter des signaux de sortie des capteurs CPV (5), le contrôleur (9) commandant les deux dispositifs (12, 13) en fonction de la nature des signaux de sortie des capteurs CPV (5).

3. Dispositif selon l'une des revendications 1 ou 2, **caractérisé en ce qu'**il existe un dispositif supplémentaire pour l'ajustement de la plaque de lentilles (2) dans le sens vertical.

4. Dispositif selon l'une des revendications 1 à 3, **caractérisé en ce qu'**il possède un dispositif destiné à l'injection sous pression sans joints d'une masse d'étanchéité au silicone (15) après avoir accompli l'ajustement de la plaque de lentilles (2).

5. Procédé d'ajustement optimal de la plaque de lentilles (2) dans un module photovoltaïque à concentration (CPV), lequel se compose d'une pluralité de capteurs CPV (5) disposés en une surface dans une plaque support de capteurs (1) et d'une pluralité de lentilles montées au-dessus de celle-ci dans une plaque de lentilles (2) à un écart correspondant à leur distance focale, les deux plaques (1, 2) étant logées dans un boîtier insensible aux intempéries, possédant les caractéristiques suivantes :
a) par rapport à une plaque support de capteurs (1) comprenant une pluralité de capteurs CPV (5), les capteurs CPV (5) pouvant être alimentés avec une tension électrique réglable et/ou un courant électrique réglable, en vue de l'exciter pour qu'elle émette de la lumière, la plaque de lentilles (2) est fixée de manière mobile, la plaque de lentilles (2) possédant une pluralité de lentilles correspondant à la pluralité de capteurs CPV (5), et les lentilles étant montées sensiblement en parallèle avec la position horizontale des capteurs CPV (5) dans la zone de leur axe optique,
b) une plaque de lentilles fixe (3) est montée en parallèle avec la position de la plaque de lentilles (2), cette plaque de lentilles fixe étant traversée par un rayonnement de faisceaux parallèles, et des capteurs de quadrant (4) se trouvant à un écart correspondant à la distance focale des lentilles de la plaque de lentilles fixe (3) sur le côté à l'opposé de la plaque de lentilles (2),
c) la plaque de lentilles (2) est décalée dans le plan dans deux directions horizontales orientées perpendiculairement l'une par rapport à l'autre par deux dispositifs (12, 13) jusqu'à ce qu'une orientation optimale des axes optiques des capteurs CPV (5) et des lentilles de la plaque de lentilles (2) soit atteinte au moyen des capteurs de quadrant (4), les deux dispositifs (12, 13) étant commandés en fonction de la nature des signaux de sortie des capteurs de quadrant (4) et de la puissance injectée des capteurs CPV (5) au moyen d'un contrôleur (9) destiné à interpréter les signaux de sortie des capteurs de quadrant (4).

6. Procédé d'ajustement optimal de la plaque de lentilles (2) dans un module photovoltaïque à concentration (CPV), lequel se compose d'une pluralité de capteurs CPV (5) disposés en une surface dans une plaque support de capteurs (1) et d'une pluralité de lentilles montées au-dessus de celle-ci dans une plaque de lentilles (2) à un écart correspondant à leur distance focale, les deux plaques (1, 2) étant logées dans un boîtier insensible aux intempéries, possédant les caractéristiques suivantes :
a) par rapport à une plaque support de capteurs (1) comprenant une pluralité de capteurs CPV (5), la plaque de lentilles (2) est fixée de manière mobile, la plaque de lentilles (2) possédant une pluralité de lentilles correspondant à la pluralité de capteurs CPV (5), et les lentilles étant montées sensiblement en parallèle avec la position horizontale des capteurs CPV (5) dans la zone de leur axe optique,
b) une plaque de lentilles fixe (3) est montée en parallèle avec la position de la plaque de lentilles (2), des sources de lumière (6) se trouvant à un écart correspondant à la distance focale des lentilles de la plaque de lentilles fixe (3) sur le côté à l'opposé de la plaque de lentilles (2),
c) la plaque de lentilles (2) est décalée dans le plan dans deux directions horizontales orientées perpendiculairement l'une par rapport à l'autre par deux dispositifs (12, 13) jusqu'à ce qu'une orientation optimale des axes optiques des capteurs CPV (5) et des lentilles de la plaque de lentilles (2) soit atteinte au moyen de la détermination d'un rendement optimal en matière de puissance électrique, les défauts d'homogénéité distribués statistiquement dans la structure interne du capteur CPV (5) concerné pouvant être pris en compte.

7. Procédé selon l'une des revendications 5 ou 6, **caractérisé en ce qu'**il existe un dispositif supplémentaire pour l'ajustement de la plaque de lentilles (2) dans le sens vertical.

8. Procédé selon l'une des revendications 5 à 7, **caractérisé en ce qu'**après avoir accompli l'ajustement de la plaque de lentilles (2), une injection sous pression sans joints d'une masse d'étanchéité au silicone (15) est effectuée au moyen d'un dispositif.
